# EUROPÄISCHE PATENTSCHRIFT

(11) **EP 2 491 577 B1**
(45) Veröffentlichungstag und Bekanntmachung des Hinweises auf die Patenterteilung: **15.10.2014**
(21) Anmeldenummer: 11767185.9
(22) Anmeldetag: 30.08.2011
(51) Int. Cl.: H01L 21/225, H01L 31/18

(54) **VERFAHREN ZUM AUSBILDEN EINES DOTIERSTOFFPROFILS**
METHOD FOR FORMING A DOPANT PROFILE
PROCÉDÉ DE FORMATION D'UN PROFIL DE DOPANT

(30) Priorität: 06.07.2011 DE 102011051606; 03.09.2010 DE 102010037321; 30.08.2010 DE 102010037238
(43) Veröffentlichungstag der Anmeldung: 29.08.2012
(73) Patentinhaber: Fraunhofer Gesellschaft zur Förderung der angewandten Forschung e.V., 80686 München (DE)
(72) Erfinder: BLENDIN, Gabriele, 63571 Gelnhausen (DE); HORZEL, Joerg, B-3001 Heverlee (BE); LACHOWICZ, Agata, 63791 Karlstein (DE); SCHUM, Berthold, 63599 Biebergemünd (DE)
(74) Vertreter: Stoffregen, Hans-Herbert
(86) Internationale Anmeldenummer: PCT/EP2011/064851
(87) Internationale Veröffentlichungsnummer: WO 2012/028593

(56) Entgegenhaltungen:
- WO-A2-2010/066626
- WEISS, M. ET AL: "Selective emitter from structured diffusion source proves its capability of industrial realization", 24ST EUROPEAN PHOTOVOLTAIC SOLAR ENERGY CONFERENCE, PROCEEDINGS OF THE 24ST INTERNATIONAL CONFERENCE, WIP-RENEWABLE ENERGIES, 21. September 2009 (2009-09-21), Seiten 1941-1944, XP040530081, ISBN: 978-3-936338-25-6
- A. Dastgheib-Shirazi: "SELECTIVE EMITTER FOR INDUSTRIAL SOLAR CELL PRODUCTION: A WET CHEMICAL APPROACH USING A SINGLE SIDE DIFFUSION PROCESS", 23rd European Photovoltaic Solar Energy Conference and Exhibition, 5. August 2008 (2008-08-05), Seiten 1-3, XP55012251, Gefunden im Internet: URL:http://www.ise.fraunhofer.de/veroeffen tlichungen/nach-jahrgaengen/2008/veroeffen tlichungen/selective-emitter-for-industria l-solar-cell-production-a-wet-chemical-app roach-using-a-single-side-diffusion-proces s/at_download/file [gefunden am 2011-11-16]
- NGUYEN V. ET AL: "ANALYSIS OF SCREEN PRINTED SILICON SOLAR CELL EMITTERS", 24ST EUROPEAN PHOTOVOLTAIC SOLAR ENERGY CONFERENCE, PROCEEDINGS OF THE 24ST INTERNATIONAL CONFERENCE, WIP-RENEWABLE ENERGIES, 21. September 2009 (2009-09-21), Seiten 1923-1925, XP040530076, ISBN: 978-3-936338-25-6
- JANSSENS T ET AL: "Advanced phosphorous emitters for high efficiency Si solar cells", PHOTOVOLTAIC SPECIALISTS CONFERENCE (PVSC), 2009 34TH IEEE, IEEE, PISCATAWAY, NJ, USA, 7. Juni 2009 (2009-06-07), Seiten 878-882, XP031626436, ISBN: 978-1-4244-2949-3
- BAZER-BACHI B. ET AL: "Control of Phosphorus diffusion using LYDOP technology for obtaining various phosphorus emitters", THE COMPILED STATE-OF-THE-ART OF PV SOLAR TECHNOLOGY AND DEPLOYMENT : 23RD EUROPEAN PHOTOVOLTAIC SOLAR ENERGY CONFERENCE, EU PVSEC ; PROCEEDINGS OF THE INTERNATIONAL CONFERENCE, HELD IN VALENCIA, SPAIN, 1 - 5 SEPTEMBER 2008, WIP-RENEWABLE ENERGIES, M, 1. September 2008 (2008-09-01), XP040529139, ISBN: 978-3-936338-24-9
- KAGILIK A. ET AL: "Emitter optimization of MC-Silicon solar cells by using dry etching technique", NINETEENTH EUROPEAN PHOTOVOLTAIC SOLAR ENERGY CONFERENCE : PROCEEDINGS OF THE INTERNATIONAL CONFERENCE HELD IN PARIS, FRANCE, 7 - 11 JUNE 2004, MÜNCHEN : WIP-MUNICH ; FLORENCE : ETA-FLORENCE, 7. Juni 2004 (2004-06-07), XP040510432, ISBN: 978-3-936338-15-7

## Beschreibung

Die Erfindung bezieht sich auf ein Verfahren zum Ausbilden eines von einer Oberfläche eines platten- oder waferförmigen siliciumbasierten Halbleiterbauelements aus Silicium ausgehenden Dotierstoffprofils mit Phosphor als Dotierstoff durch Applizieren einer Phosphordotierstoffquelle auf die Oberfläche, Ausbilden eines ersten Dotierstoffprofils bei auf der Oberfläche vorhandener Dotierstoffquelle, Entfernen der Dotierstoffquelle und Ausbilden eines im Vergleich zu dem ersten Dotierstoffprofil eine größere Tiefe aufweisenden zweiten Dotierstoffprofils, wobei während des Ausbildens des ersten Dotierstoffprofils auf der Oberfläche SiₓP_{y}-Phasen und/oder SiₓP_{y}O_{z}-Phasen entstehen.

Zur Herstellung eines hochdotierten Oberflächenbereichs eines aus p-Silicium bestehenden Halbleiterbauelements, um bei einer Solarzelle einen Emitter auszubilden und gleichzeitig eine gute Kontaktierung zu ermöglichen, kann nach dem Stand der Technik eine Phosphorquelle appliziert werden, um von dieser ausgehend Phosphor in den Halbleiter einzutreiben. Dabei entstehen bei einer hohen Dotierstoffkonzentration an Phosphor üblicherweise SiₓP_{y}-Präzipitate in der Siliciumoberfläche. Die hohen Dotierstoffkonzentrationen sind jedoch nach allgemeiner Auffassung erforderlich, um in für die Massenproduktion von Siliciumsolarzellen geeigneten Verfahren ausreichend tiefe Emitter zu erzeugen (≥ 0,2 µm tief), die gleichzeitig eine ausreichende Oberflächenkonzentration an Phosphor aufweisen, die die Verwendung von Ag-Pasten zur Kontaktbildung zulassen. Üblicherweise wird der Dotierstoff in einem Temperatur(T)-Zeit (t)-Behandlungsschritt eingetrieben.

Vorteilhafterweise kann ein Verfahren zum Einsatz gelangen, bei dem der Dotierstoff in zwei T-t-Behandlungsschritten eingetrieben wird, wobei optional nach dem ersten T-t-Schritt die Diffusionsquelle entfernt wird (WO-A-2010/066626).

Entfernen der Dotierstoffquelle nach dem ersten Diffusionsschritt heißt, dass noch vorhandener Dotierstoff sowie während der Temperaturbehandlung entstandenes Phosphorsilikatglas entfernt werden.

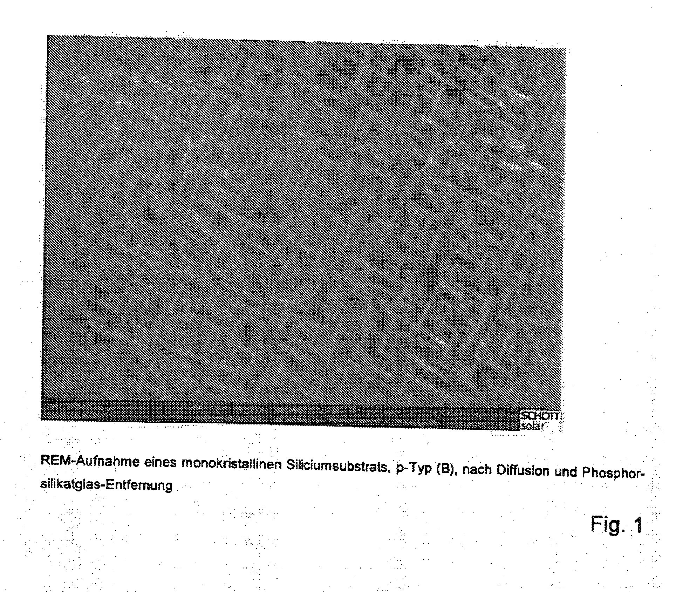

Im Verlaufe der typischen Diffusionsverfahren wird eine Phase der Zusammensetzung SiₓP_{y} bzw. Siₓ,P_{y}O_{z}, die in Form von orientierungsabhängigen Nadeln (siehe Fig. 1) auskristallisieren kann, in der hochdotierten oberflächennahen Si-Schicht erzeugt. Diese Präzipitate haben eine sehr geringe Leitfähigkeit, können zur Rekombination von Ladungsträgern führen, Kristallgitterstörungen im Si-Kristall erzeugen und führten zu mechanischen Spannungen in der Si-Oberfläche, die die elektrischen Eigenschaften des Halbleiterbauelements negativ beeinflussen können.

Um Solarzellen mit niedrigeren Oberflächenkonzentrationen für hocheffiziente Konzepte auf dünnen Wafern herstellen zu können, ist es wichtig, einen kostengünstigen Prozess wie Inline-Prozess mit flüssigen Phosphorquellen als Dotierstoffquelle für den Diffusionsschritt zu verwenden, der keine Präzipitate in der Oberfläche der Wafer erzeugt.

Die Phasen der Zusammensetzung SiₓP_{y} bzw. Siₓ,P_{y}O_{z} bzw. die Präzipitate können durch HF - Lösungen, wie sie üblicherweise zum Entfernen der Phosphorsilicatglasschicht nach der Diffusion eingesetzt werden, nicht entfernt werden.

Der Literaturstelle D1 WEISS, M. ET AL: "Selective emitter from structured diffusion source proves its capability of industrial realization", 24ST EUROPEAN PHOTOVOLTAIC SOLAR ENERGY CONFERENCE, PROCEEDINGS OF THE 24ST INTERNATIONAL CONFERENCE, WIPRENEWABLE ENERGIES, 21. September 2009 (2009-09-21), Seiten 1941 - 1944, ist ein Verfahren zur Herstellung eines selektiven Emitters einer Silicium-Solarzelle zu entnehmen. Dabei wird in einem ersten Verfahrensschritt Phosphorsilikatglas homogen auf das Substrat abgeschieden und sodann einem kurzen Diffusionsprozess unterzogen. Mittels Maskentechnik wird sodann das Phosphorsilikatglas außerhalb der Bereiche der Frontseite entfernt, in denen Frontkontakte ausgebildet werden. Anschließend erfolgt ein hoher Temperaturverfahrensschritt, um eine hochdotierte Emitterregion in den Bereichen auszubilden, in denen das Frontgitter verlaufen soll.

Der vorliegenden Erfindung liegt die Aufgabe zugrunde, ein Verfahren der eingangs genannten Art so weiterzubilden, dass ein optimiertes Dotierstoffprofil auf einem Siliciumhalbleitermaterial, insbesondere bestimmt zur Herstellung einer Solarzelle, ausgebildet werden kann.

Die Aufgabe wird erfindungsgemäß im Wesentlichen dadurch gelöst, dass nach Ausbilden des ersten Dotierstoffprofils die Dotierstoffquelle entfernt wird und während der Ausbildung des ersten Dotierstoffprofils entstandene Phase der Zusammensetzung Siₓ-P_{y} bzw. SiₓP_{y}O_{z} bzw. die Präzipitate, die durch Auskristallisieren dieser Phasen entstanden sind, selektiv entfernt werden. Selektiv heißt dabei, dass allein die entsprechende Phase bzw. Präzipitate entfernt werden. Selektives Entfernen bedeutet dabei, dass die regulär diffundierte ca. 100 nm tiefe Emitterschicht nicht geätzt wird. Das selektive Entfernen der SiₓP_{y}- bzw. SiₓP_{y}O_{z} -Phase bzw. der Präzipitate sollte dabei das Entfernen von elektrisch inaktivem Phosphor und freiem Phosphor einschließen.

Die Erfindung zeichnet sich insbesondere durch ein Verfahren zum Ausbilden eines von einer Oberfläche eines platten- oder waferförmigen siliciumbasierten Halbleiterbauelements ausgehenden Dotierstoffprofils mit Phosphor als Dotand durch Applizieren einer Phosphordotierstoffquelle auf die Oberfläche, Ausbilden eines ersten Dotierstoffprofils bei auf der Oberfläche vorhandener Dotierstoffquelle, Entfernen der Dotierstoffquelle und Ausbilden eines im Vergleich zu dem ersten Dotierstoffprofil eine größere Tiefe aufweisenden zweiten Dotierstoffprofils dadurch aus, dass nach Ausbilden des ersten Dotierstoffprofils die Dotierstoffquelle entfernt und auf der Oberfläche vorhandene Siₓ₋Py Phasen, elektrisch inaktives Phosphor und freier Phosphor, also nicht in das Si-Kristallgitter eingebauter Phosphor, entfernt werden, wobei anschließend der zweite Temperaturbehandlungsschritt zur Ausbildung des endgültigen (zweiten) Dotierstoffprofils durchgeführt wird, ohne dass sich Präzipitate auf der Oberfläche ausbilden.

Selektives Entfernen der SiₓP_{y}- bzw. SiₓP_{y}O_{z}-Phase bzw. der Präzipitate und das Entfernen des elektrisch inaktiven Phosphors und des freien Phosphors können gleichzeitig erfolgen bzw. erfolgen gleichzeitig. Insoweit ist das Merkmal "selektiv" auszulegen.

Freies Phosphor ist dabei Phosphor, das nicht in das Si-Kristallgitter des Halbleiterbauelements eingebracht ist.

Unter SiₓP_{y} Phasen, die auch SiₓP_{y}O_{z} einschließen, versteht man jede Form der Phase, insbesondere Präzipitate.

Optional kann gleichzeitig im nahe an der Oberfläche liegenden Bereich des Wafers ein Anteil des überschüssigen Phosphors im Halbleiterbauelement wie Wafer mit entfernt werden.

Nahe bedeutet bis maximal 10 nm. Insoweit umfasst dieses Ätzen des oberflächennahen Bereichs die Erfindung.

Erfindungsgemäß wird ein an und für sich bekannter zweistufiger Diffusionsprozess zur Herstellung einer mit Phosphor dotierten Schicht aus Silicumwafern, die zur Herstellung von Solarzellen auf Siliciumwaferbasis benötigt werden, dahingehend weitergebildet, dass nach dem ersten Diffusionsschritt SiₓP_{y} und SiₓP_{y}O_{z} (SIP-Verbindungen), elektrisch inaktiver Phosphor und nicht ins Si-Kristallgitter eingebauter Phosphor entfernt werden. Dabei ist insbesondere vorgesehen, dass das selektive Entfernen der Präzipitate durch Anwendung einer alkalischen Ätzlösung, die ein Oxidationsmittel enthält, durchgeführt wird, wobei die alkalische Ätzlösung die Oberfläche über eine Zeit t₃ mit 15 sec ≤ t₃ ≤ 5 min, insbesondere 30 sec ≤ t₃ ≤ 60 sec, bei einer Temperatur T₃ mit RT (Raumtemperatur) ≤ T₃ ≤ 60 °C, vorzugsweise 35 °C ≤ T₃ < 45 °C, kontaktiert.

Unabhängig hiervon sieht die Erfindung vor, dass zur Ausbildung des ersten Dotierstoffprofils das Halbleiterbauelement einer Temperatur T₁ mit T₁ ≥ 750 °C über eine Zeit t₁ ausgesetzt wird, während der in der Oberflächenschicht des Halbleiterbauelements in einem Dickenbereich D mit 150 nm ≥ D ≥ 20 nm eine Phosphorkonzentration K mit K ≥ 10²⁰ Phosphoratome/ cm³ an der Oberfläche entsteht, und dass zur Ausbildung des zweiten Dotierstoffprofils das Halbleiterbauelement einer Temperatur T₂ über eine Zeit t₂ ausgesetzt wird, wobei t₂ > t₁ ist. Dabei ist insbesondere vorgesehen, dass die Temperatur T₂ ≥ T₁, insbesondere T₂ in etwa T₁ ist, wobei 750 °C ≤ T₁, T₂ ≤ 1000 °C, insbesondere 800 °C ≤ T₁, T₂ ≤ 900 °C ist.

Die Phosphorkonzentration im Oberflächenbereich weist sodann bis zu einer Tiefe bis 20 nm von der Oberfläche ausgehend eine Konzentration K ≤ 5 * 10²⁰ Phosphoratome/cm³ auf.

Die Dicke D₀ des Bereichs, in dem die Phosphor-Konzentration größer als 10²⁰ at/cm³, insbesondere mehr als 5 * 10²⁰ at/cm³ betragen kann, d. h., größer als die Löslichkeit des Phosphors im Silizium bei den angewandten Temperaturen, liegt zwischen 0 nm und 50 nm. Der nicht im Silizium gelöste Phosphor befindet sich in den SiP-Phasen und in den Präzipitaten.

Ferner sollte das erste Dotierstoffprofil während einer Zeit t₁ mit 0,5 min ≤ t₁ ≤ 10 min, insbesondere 1 min ≤ t₁ ≤ 5 min, und das zweite Dotierstoffprofil während einer Zeit t₂ mit 10 min ≤ t₂ ≤ 180 min, insbesondere 20 min ≤ t₂ ≤ 80 min, ausgebildet werden.

Insbesondere besteht auch die Möglichkeit, diesen Prozess nur selektiv auf Teilen der Waferoberfläche durchzuführen. Hierzu können die Bereiche, auf denen die Präzipitate vermieden werden sollen, mit einer entsprechenden Ätzpaste bedruckt werden. Die Ätzpasten können entsprechend der einzusetzenden Ätzlösungen zusammengesetzt sein.

Insbesondere ist auch vorgesehen, dass nach Ausbilden des ersten Dotierstoffprofils und Entfernen der Dotierstoffquelle eine ätzresistente Maske auf die Oberfläche aufgebracht wird, die eine Geometrie aufweist, die der einer auf die Oberfläche aufzubringenden Metallisierung entspricht.

Die Phosphordiffusion kann auf unterschiedliche Art und Weise stattfinden. Es kann z.B. POCl₃ als P-Quelle verwendet werden und der Prozess als Batchprozess ablaufen. Es kann aber auch ein Inlineverfahren verwendet werden.

Bei diesen Inlineverfahren können unterschiedliche P-Quellen verwendet werden, z. B. H₃PO₄ in Lösungsmittel oder in Wasser gelöst, die mit einer Spin-on-, Sprüh-, Nebel- oder Tauch-Anlage aufgebracht werden können. Nach dem Aufbringen der Phosphorquelle werden die Siliciumwafer in einem Durchlaufofen einem ersten T (Temperatur)-t (Zeit)-Profil unterzogen. Das T-t-Profil ist so ausgelegt, dass der Phosphor in das Silicium teilweise eindiffundiert. Auf der Oberfläche entsteht durch Reaktion mit Sauerstoff eine Phosphorsilikatglasschicht (PSG).

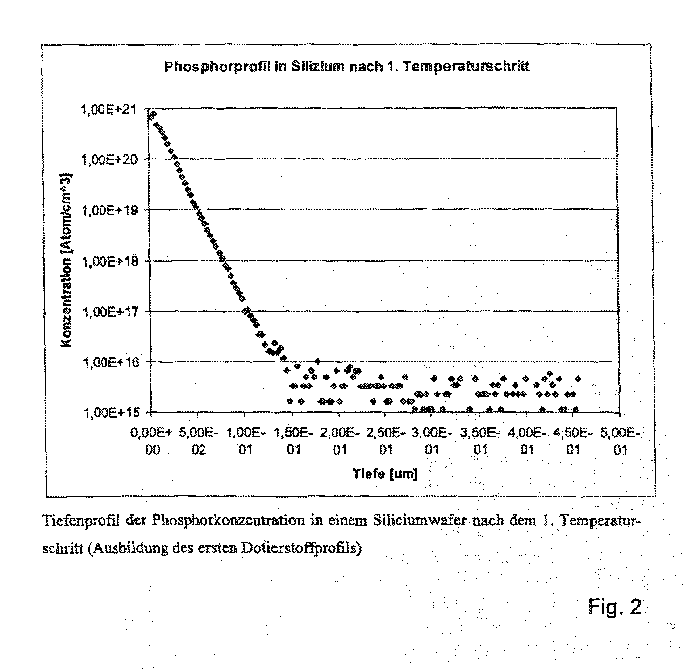

In diesem ersten Hochtemperaturschritt wird ein flaches, d.h. nicht tief eingetriebenes, Phosphorprofil erzeugt. Die Tiefe dieses Profils liegt in der Größenordnung von 100 nm. In Fig. 2 ist ein entsprechendes erstes Dotierstoffprofil in Form eines Phosphorprofils in Silicium nach der ersten Wärmebehandlung dargestellt, wobei das Substrat einer Temperatur von 870 °C über eine Zeit von 2 min ausgesetzt war.

Solch ein Profil kann auch mit einem POCl3-Diffusionsprozess hergestellt werden, bei dem mit entsprechender Gasführung ebenfalls Präzipitate entstehen können.

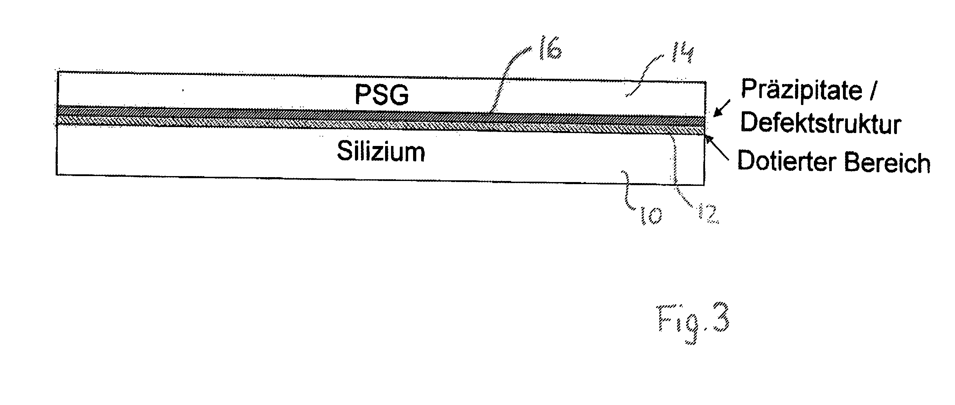

Bei diesem ersten Diffusionsschritt entsteht bei sehr hohen Phosphorkonzentrationen, die insbesondere im Inlineverfahren nötig sind, an der Grenzfläche des Siliciumwafers zum PSG eine Phase der Zusammensetzung SiₓP_{y} bzw. SiₓP_{y}O_{z}, die im weiteren Verlauf der Diffusion in Form von nadelförmigen Präzipitaten auskristallisieren kann. Dies wird anhand der Fig. 3 prinzipiell verdeutlicht. So wird rein prinzipiell ein Querschnitt eines aus Silicium bestehenden Wafers 10 dargestellt, auf dem sich durch Auftragen einer Phosphor enthaltenden Dotierstoffquelle im Oberflächenbereich ein aufgrund des eindiffundierten Phosphors entstehender dotierter n-Bereich 12 ausbildet. Dieser Bereich 12 ist von einer Phosphorsilikatglasschicht 14 abgedeckt. Ferner ist prinzipiell dargestellt, dass sich im Grenzbereich zwischen dem Si-Wafer, d.h. dem dotierten Bereich 12, und dem Phosphorsilikatglas 14 aus der SiₓP_{y} bzw. SiₓP_{y}O_{z}-Phase Präzipitate 16 ausgebildet haben, die eine Defektstruktur bilden.

Die auskristallisierten Präzipitate sind um Größenordnungen schlechter leitend als regulär diffundierte Bereiche, lassen sich nicht mit den üblichen Ätzmischungen zur Entfernung von PSG wegätzen und können zusätzliche Störungen und Versetzungen in darunter liegenden Kristallzonen verursachen. Durch unterschiedliche Gitterkonstanten erzeugen die SiP-Verbindungen im Si-Gitter Versetzungen und Spannungen. Diese Defekte reduzieren die Qualität der Halbleiterbauelemente wie Solarzellen.

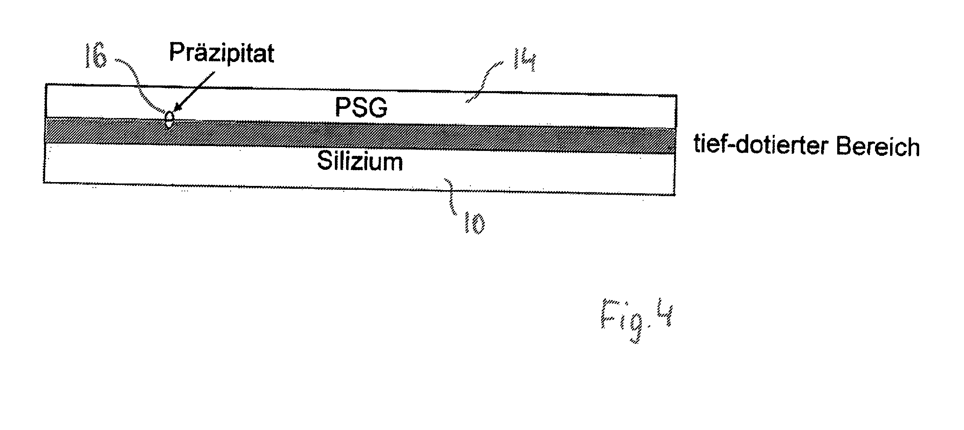

Die den Stand der Technik prinzipiell verdeutlichende Fig. 4 zeigt, dass an der Oberfläche des n-dotierten Bereichs 12 eines nach einem Standardprozess behandelten Wafers 10 Präzipitate 16 auskristallisiert sind. Dieses Auskristallisieren ist nach einer langen Diffusionszeit (z. B. mehr als 10 min) mit einer hohen P-Konzentration auf der Oberfläche des Wafers in Form von SiP-Verbindungen zu beobachten, die mit dem (Rasterelektronenmikroskop) REM deutlich sichtbar werden.

Sie bilden Stäbchen an der Oberfläche mit den Maßen: Breite 10 - 20 nm, Länge 100 - 200 nm. Die Größe und Häufigkeit dieser Präzipitate hängt von der P-Konzentration und der Diffusionszeit ab.

Nach dem ersten Hochtemperaturschritt mit einer hochkonzentrierten P-Quelle (Phosphor liegt während des Temperaturschritts stets im Überschuss vor) wird das PSG aufgelöst und die SiₓP_{y} bzw. SiₓP_{y}O_{z} - Phase sowie der elektrisch inaktive Phosphor und nicht ins Si-Kristallgitter eingebauter Phosphor erfindungsgemäß entfernt, ohne dass im Wesentlichen die regulär diffundierte, ca. 100 nm tiefe Emitterschicht des Substrats wie Wafers geätzt wird. Der Ätzschritt wird dabei derart durchgeführt, dass die Konzentration des Phosphors im Oberflächenbereich des Wafers grundsätzlich dem Wert der Löslichkeit von Phosphor in Silicium, d. h. 5 * 10²⁰ at/cm³ entspricht oder geringer ist. Hierdurch wird sichergestellt, dass im Verlauf der weiteren Diffusion Präzipitate nicht mehr entstehen können.

Während des Ätzens der Präzipitate kann gegebenenfalls eine oberflächennahe Schicht des Substrats, also insbesondere der Emitterschicht geätzt werden. Dieser Bereich beläuft sich auf üblicherweise maximal 20 nm. Dieses Ätzen des oberflächennahen Bereichs ist somit unter die erfindungsgemäße Lehre zu subsumieren.

Des Weiteren ist darauf hinzuweisen, dass grundsätzlich vor Ätzen der Präzipitate die Dotierstoffquelle bzw. das PSG entfernt wird. Hierzu wird üblicherweise eine HF-Lösung benutzt.

Das Entfernen des PSG sowie der SiP-Verbindungen, des elektrisch inaktiven Phosphors und nicht ins Si-Kristallgitter eingebauten Phosphors und eventuell überschüssigen Phosphors in der Oberfläche kann nur auf bestimmten Bereichen der Emitteroberfläche, d. h., selektiv vorgenommen werden. Hierzu muss nach dem ersten Temperaturschritt eine ätzresistente Maske in gleicher Form wie das Metallisierungs-Grid aufgebracht werden. Danach wird auch bei diesen Wafern das PSG und die SiP-Verbindungen sowie eventuell ein Teil der hochdotierten Schicht entfernt, aber nur in den Zwischenbereichen, in denen keine Metallkontakte aufgebracht werden sollen.

Weiterhin ist es möglich, diese Wafer mit PSG auf der Oberfläche mit dem Laser selektiv einzudiffundieren und dann erst den Ätzschritt bzw. Reinigungsschritl durchzuführen.

Soll ein selektives Entfernen des Phosphorsilikatglases sowie der Präzipitate und somit auch des inaktiven Phosphors und des nicht ins Si-Kristallgitter eingebauten Phosphors erfolgen, also ein Entfernen, das nur bereichsweise auf der Vorder- oder Frontseite des Halbleiterbauelements wie Wafers einer Solarzelle erfolgt, kann eine Maskierung benutzt werden. Es besteht auch die Möglichkeit, den Ätzschritt zum Entfernen der SiₓP_{y}-Verbindungen, des inaktiven Phosphors sowie des freien Phosphors mittels einer Ätzpaste durchzuführen, die selektiv auf zu ätzende Bereiche aufgebracht wird.

Die Phase der Zusammensetzung SiₓP_{y} bzw. Siₓ,P_{y}O_{z} bzw. die Präzipitate sowie der elektrisch inaktive Phosphor und der nicht ins Si-Kristallgitter eingebaute Phosphor werden nach dem ersten Diffusionsschritt vorzugsweise nasschemisch, durch Tauchen in eine wässrige alkalische Lösung, die ein Oxidationsmittel enthält, selektiv entfernt.

Bevorzugterweise wird als alkalische Komponente für die wässrige alkalische Lösung eine Komponente aus der Gruppe NaOH, KOH verwendet. Als Oxidationsmittel ist bevorzugterweise eine Komponente aus der Gruppe Natriumhypochlorit, Natriumperoxodisulfat, Wasserstoffperoxid zu nennen.

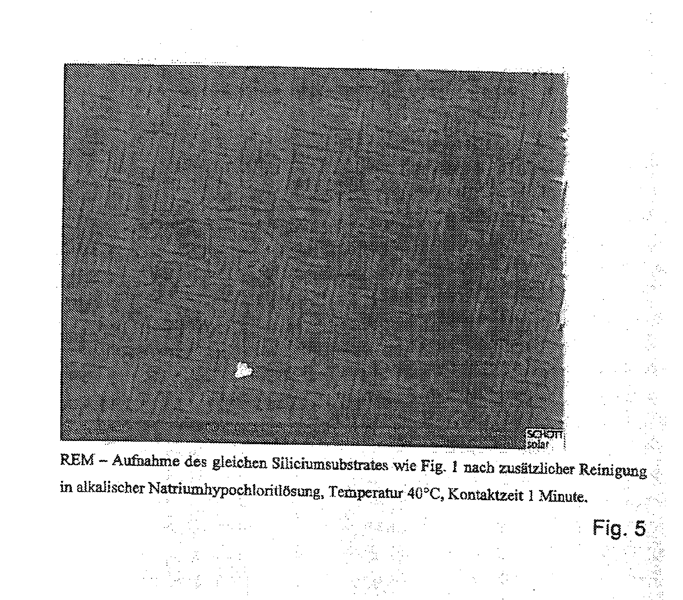

Wendet man eine entsprechende wässrige alkalische Lösung mit einem Oxidationsmittel über eine Kontaktzeit zwischen 5 sec bis 5 min, vorzugsweise 30 sec bis 60 sec, bei einer Temperatur zwischen 20 °C und 60 °C, insbesondere zwischen 35 °C und 45 °C, an, so werden selektiv die Präzipitate entfernt. Dies äußert sich durch Gräben, wie diese der Fig. 5 zu entnehmen sind, die eine Röntgenelektronenmikroskopaufnahme eines Siliciumsubstrats wiedergibt, das der der Fig. 1 entspricht. Bei dem selektivem Entfernen soll die regulär diffundierte ca. 100 nm dicke Emitterschicht nicht geätzt werden. In diesem Sinne ist selektiv zu verstehen.

Nachdem das selektive Entfernen der Präzipitate im Wesentlichen ohne Ätzen der hochdotierten Oberflächenschicht erfolgt ist, wird das Halbleiterbauelement bzw. - substrat ohne eine erneute Zuführung einer Phosphorquelle einem weiteren T-t-Behandlungsschritt unterzogen. Dabei ist die Zeit, innerhalb der das zweite Diffusionsprofil ausgebildet ist, deutlich länger als die zur Ausbildung des ersten Dotierstoffprofils.

Während des zweiten Behandlungsschritts diffundiert das bereits im ersten Verfahrensschritt eindiffundierte Phosphor tiefer in das Halbleitersubstrat ein, so dass das zweite Phosphordotierprofil entsteht, ohne dass jedoch die störenden SiₓP_{y}-Verbindungen bzw. Siₓ,P_{y}O_{z}- Verbindungen und die aus diesen auskristallisierten Präzipitate auftreten.

In Abhängigkeit von der Zeitdauer und der Temperatur kann das zweite Dotierstoffprofil eine geringe Oberflächenkonzentration und eine sehr große Eindringtiefe aufweisen.

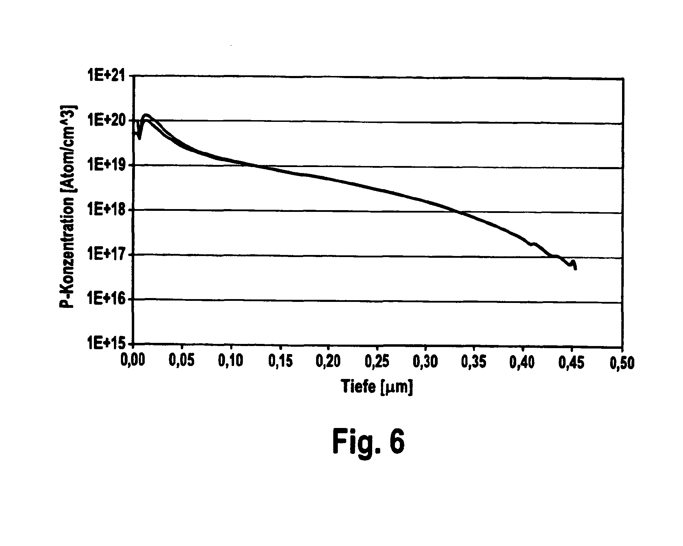

Dies ist der Fig. 6 zu entnehmen, der ein zweites Dotierstoffprofil in Form einer Phosphorkonzentration nach dem zweiten Temperaturschritt zu entnehmen ist. Die zur Anwendung gelangte Temperatur lag bei 830 °C. Die Zeitdauer, über die die Temperatur auf den Wafer einwirkte, belief sich auf 60 min.

Zum selektiven Entfernen der Präzipitate kann eine alkalische Ätzlösung mit zumindest einem Oxidationsmittel aus der Gruppe Peroxodisulfate, Peroxomonosulfate, Hypochlorit, Wasserstoffperoxid verwendet werden, wobei insbesondere Natriumhypochlorit und Natriumperoxodisulfat zu nennen sind. Als alkalische Komponente der alkalischen Ätzlösung wird zumindest eine Komponente aus der Gruppe NaOH, KOH, Ammoniak, Ammoniakderivate, Alkylamine, Alkanolamine, Hydroxyalkyl-Alkylamine, Polyalkyleamine, cyclische N-substituierte Amine und TMAH verwendet.

Ferner kann die alkalische Ätzlösung zumindest eine Komponente aus der Gruppe Komplexierungsmittel, Tenside, Stabilisatoren enthalten. Dabei kommen insbesondere als Komplexierungsmittel ein Komplexbildner aus der Gruppe Hydroxyphenole, Aminderivate (Chelatbildner) wie Nitrilotriessigsäure (NTA) oder Ethylendiamintetraessigsäure (EDTA), Hydroxycarbonsäuren, Polyalkohole, Phosphonsäuren, Polyphosphate in Frage. Als Hydroxycarbonsäuren kommen Zitronensäure oder Weinsäure, als Polyalkohole kommen Glycerin, Sorbitol und andere Zucker und Zuckeralkohole in Frage.

Die Kontaktzeit der Oberfläche des Halbleiterbauelements mit der alkalischen Ätzlösung sollte 5 sec bis 5 min, vorzugsweise 30 sec bis 60 sec, bei einer Temperatur zwischen Raumtemperatur und 60 °C, vorzugsweise zwischen 35 °C und 45 °C betragen.

Bei Verwendung einer entsprechenden Ätzlösung und insbesondere unter Berücksichtigung der zuvor genannten Parameter werden die Präzipitate, die nach dem 2. Temperaturschritt ohne optimierte Parameter zu sehen sind, weggeätzt, so dass sich leere Gräben ergeben.

Nachdem die Präzipitate weggeätzt sind, wird das Halbleiterbauelement, also insbesondere der Wafer ohne Zuführung einer Dotierstoffquelle einer erneuten T-t-Behandlung unterzogen. Dabei ist die Zeit im Vergleich zur Ausbildung des ersten Dotierstoffprofils erheblich größer zu wählen. Insbesondere sollte zur Ausbildung des zweiten Dotierstoffprofils eine Temperatur zwischen 750 °C und 1000 °C über einen Zeitraum zwischen 10 min und 120 min, insbesondere zwischen 20 min und 60 min einwirken. Demgegenüber beläuft sich die Zeit zur Ausbildung des ersten Dotierstoffprofils zwischen 0,5 min und 10 min, vorzugsweise zwischen 1 min und 5 min. Die Temperatur wird üblicherweise in der gleichen Größenordnung gewählt.

Der eindiffundierte Phosphor nach dem ersten T-t-Profil kann sodann während des zweiten T-t-Profils sehr tief in das Halbleitersubstrat eingetrieben werden. Die Tiefe hängt von der Temperatur und Zeitdauer (zweites T-t-Profil) ab.

Wird der Prozess selektiv angewandt, d. h., dass nur z. B. nicht durch eine Maske abgedeckte Bereiche geätzt werden, um die SiₓP_{y}- bzw. SiₓP_{y}O_{z}-Phasen bzw. Präzipitate, den elektrisch inaktiven Phosphor und den freien Phosphor zu entfernen, um sodann nach Entfernen der Maske in den zuvor abgedeckten Bereichen eine Metallisierung aufzubringen, sind im Bereich unterhalb der Metallisierung Standard-P-Profile erzielbar, die mit jeder kommerziellen Paste mit Siebdruck kontaktiert werden können. Im Zwischenfingerbereich hat das Dotierstoffprofil eine geringere Oberflächenkonzentration und ist in der Oberfläche defektarm, da hier die Präzipitate vermieden werden und deshalb keine Defekte die Solarzellenleistung begrenzen.

Die Erfindung zeichnet sich daher auch dadurch aus, dass insbesondere unter Anwendung einer ätzresistenten Maske oder eines bereichsweisen Auftragens einer Ätzpaste ausschließlich bereichsweise die SiₓP_{y}-Phasen, elektrisch inaktives Phosphor und nicht ins Si-Kristallgitter eingebautes Phosphor entfernt werden.

Optional besteht auch die Möglichkeit, mit den angegebenen Ätzlösungen die Präzipitate nach dem vollständigen Diffusionsschritt von den Waferoberflächen zu entfernen.

Unabhängig hiervon zeichnet sich die Erfindung dadurch aus, dass das zweite Dotierstoffprofil derart ausgebildet ist, dass sich im oberflächennahen Bereich des Halbleiterbauelements bis zu einer Tiefe von 40 nm eine Phosphorkonzentration zwischen 1 * 10¹⁹ P/cm³ und 5 * 10²⁰ P/cm³ ergibt. Weiterhin kann durch Einstellen des Temperatur(T)-Zeit(t)-Profils im zweiten Temperaturschritt (Diffusionsschritt) die Tiefe des Profils variiert werden, so dass sich in einem Abstand D mit D ≅ 500 nm von der Oberfläche des Halbleiterbauelements eine Phosphorkonzentration von zumindest 1 * 10¹⁶ P/cm³ ergibt, wie dies z. B. in Fig. 6 dargestellt ist.

Des Weiteren ist darauf hinzuweisen, das bevorzugterweise als Dotierstoffquelle eine Phosphorsäure enthaltende Lösung verwendet wird. Optional kann aber auch eine kurze POC13-Diffusion als erster Prozessschritt verwendet werden.

Die beigefügten Figuren zeigen:
- Fig. 1: eine Aufnahme eines monokristallinen Siliciumsubstrats (p-Typ) nach Phosphorsitikatglasentfernung,
- Fig. 2: eine Darstellung des mit SIMS (Sekundär-Ionen-Massen-Spektrometer) gemessenen Phosphorprofils nach dem 1. Temperaturschritt (1. Dotierstoffprofil),
- Fig. 3: eine Prinzipdarstellung eines monokristallinen Si-Wafers nach dem ersten Temperaturschritt,
- Fig. 4: eine weitere Prinzipdarstellung eines monokristallinen Si-Wafers,
- Fig. 5: eine Rasterelektronenmikroskop-Aufnahme des der Fig. 1 zu entnehmenden Siliciumsubstrats nach Entfernung der Präzipitate in alkalischer Natriumhypochloritlösung bei einer Temperatur von 40 °C und einer Kontaktzeit von 1 min und
- Fig. 6: eine Darstellung eines mit SIMS gemessenen Phosphorprofils, welches mit dem optimierten Prozess zur Vermeidung von Präzipitaten hergestellt wurde, nach dem 2. Temperaturschritt (2. Dotierstoffprofil).

## Patentansprüche

1. Verfahren zum Ausbilden eines von einer Oberfläche eines platten- oder waferförmigen siliciumbasierten Halbleiterbauelements ausgehenden Dotierstoffprofils mit Phosphor als Dotand durch Applizieren einer Phosphordotierstoffquelle auf die Oberfläche, Ausbilden eines ersten Dotierstoffprofils bei auf der Oberfläche vorhandener Dotierstoffquelle, Entfernen der Dotierstoffquelle und Ausbilden eines im Vergleich zu dem ersten Dotierstoffprofil eine größere Tiefe aufweisenden zweiten Dotierstoffprofils, wobei während des Ausbildens des ersten Dotierstoffprofils auf der Oberfläche SiₓP_{y}-Phasen und/oder SiₓP_{y}O_{z}-Phasen entstehen,
**dadurch gekennzeichnet,**
**dass** nach Ausbilden des ersten Dotierstoffprofils die Dotierstoffquelle entfernt und auf der Oberfläche vorhandene SiₓP_{y}-Phasen und/oder SiₓP_{y}O_{z}-Phasen selektiv entfernt werden.

2. Verfahren nach Anspruch 1,
**dadurch gekennzeichnet,**
**dass** nach Entfernen der Dotierstoffquelle auf der Oberfläche vorhandene SiₓP_{y}-bzw. SiₓP_{y}O_{z}-Phasen, elektrisch inaktiver Phoshphor und freier Phosphor entfernt werden.

3. Verfahren nach Anspruch 1 oder 2,
**dadurch gekennzeichnet,**
**dass** nach Ausbilden des ersten Dotierstoffprofils und Entfernen der Dotierstoffquelle eine ätzresistente Maske auf die Oberfläche aufgebracht wird, die eine Geometrie aufweist, die der einer auf die Oberfläche aufzubringenden Metallisierung entspricht.

4. Verfahren nach zumindest einem der vorhergehenden Ansprüche,
**dadurch gekennzeichnet,**
**dass** zur Ausbildung des ersten Dotierstoffprofils das Halbleiterbauelement einer Temperatur T₁ mit T₁ ≥ 750 °C über eine Zeit t₁ ausgesetzt wird, während der in der Oberflächenschicht des Halbleiterbauelements in einem Dickenbereich D mit 120 nm ≥ D ≥ 80 nm eine Phosphorkonzentration K mit 10¹⁶ Phosphoratome/ cm³ ≤ K ≤ 10²¹ Phosphoratome cm³, im oberflächennahen Bereich bis zu einer Dicke Dₒ mit 0 < Dₒ ≤ 50 nm eine Phosphorkonzentration Kₒ mit Kₒ ≥ 10²⁰ Phosphoratome/ cm³ entsteht, und dass zur Ausbildung des zweiten Dotierstoffprofils das Halbleiterbauelement einer Temperatur T₂ über eine Zeit t₂ ausgesetzt wird, wobei t₂ > t₁ ist.

5. Verfahren nach Anspruch 4,
**dadurch gekennzeichnet,**
**dass** die Temperatur T₂ ≥ T₁, insbesondere T₂ in etwa T₁ ist, wobei 750 °C ≤ T₁, T₂ ≤ 1000 °C, insbesondere 800 °C ≤ T₁, T₂ ≤ 900 °C ist.

6. Verfahren nach zumindest einem der vorangegangenen Ansprüche,
**dadurch gekennzeichnet,**
**dass** das erste Dotierstoffprofil während einer Zeit t₁ mit 0,5 min ≤ t₁ ≤ 10 min, insbesondere 1 min ≤ t₁ ≤ 5 min, und das zweite Dotierstoffprofil während einer Zeit t₂ mit 10 min ≤ t₂ ≤ 180 min, insbesondere 20 min ≤ t₂ ≤ 80 min, ausgebildet wird.

7. Verfahren nach zumindest einem der vorangegangenen Ansprüche,
**dadurch gekennzeichnet,**
**dass** das selektive Entfernen der Präzipitate durch Anwendung einer alkalischen Ätzlösung, die ein Oxidationsmittel enthält, durchgeführt wird, wobei die alkalische Ätzlösung die Oberfläche insbesondere über eine Zeit t₃ mit 5 sec ≤ t₃ ≤ 5 min, insbesondere 30 sec ≤ t₃ ≤ 60 sec, vorzugsweise bei einer Temperatur T₃ mit RT (Raumtemperatur) ≤ T₃ ≤ 60 °C, vorzugsweise 35 °C ≤ T₃ ≤ 45 °C, kontaktiert.

8. Verfahren nach zumindest einem der vorhergehenden Ansprüche,
**dadurch gekennzeichnet,**
**dass** die Oberfläche zum Entfernen der Präzipitate mit einer alkalischen Ätzlösung mit zumindest einem Oxidationsmittel aus der Gruppe Peroxodisulfate, Peroxomonosulfate, Hypochlorit, Wasserstoffperoxid kontaktiert wird.

9. Verfahren nach zumindest einem der vorhergehenden Ansprüche,
**dadurch gekennzeichnet,**
**dass** die alkalische Komponente der alkalischen Ätzlösung zumindest eine Komponente aus der Gruppe NaOH, KOH, Ammoniak, Ammoniakderivate, Alkylamine, Alkanolamine, Hydroxyalkyl-Alkylamine, Polyalkylenamine, cyclische N-substituierte Amine, Tetraalkylammoniumhydroxid verwendet, wobei vorzugsweise die alkalische Ätzlösung ferner zumindest eine Komponente aus der Gruppe Komplexierungsmittel, Tenside, Stabilisatoren enthält.

10. Verfahren nach Anspruch 9,
**dadurch gekennzeichnet,**
**dass** als Komplexierungsmittel ein Komplexbildner aus der Gruppe Hydroxyphenole, Aminderivate, Hydroxycarbonsäuren, Polyalkohole, Phosphonsäuren, Polyphosphate verwendet wird.

11. Verfahren nach zumindest einem der vorhergehenden Ansprüche,
**dadurch gekennzeichnet,**
**dass** als alkalische Ätzlösung eine verdünnte Hypochlorit-Lösung der Zusammensetzung
- NaOH: 1 bis 50 g/L, vorzugsweise 5 bis 10 g/L,
- Natriumhypochlorit: Lösung mit 6 bis 14 % aktivem Chlor, 150 - 750 mL/L, vorzugsweise 250 bis 300 mL/L, und
- als weitere mögliche Komponente KOH
verwendet wird.

12. Verfahren nach zumindest einem der vorhergehenden Ansprüche,
**dadurch gekennzeichnet,**
**dass** eine alkalische Ätzlösung mit Ammoniumperoxodisulfat als Oxidationsmittel mit einer Zusammensetzung verwendet wird:
- NaOH: 1 bis 50 g/L, vorzugsweise 5 bis 10 g/L,
- Ammoniumperoxodisulfat 5 bis 350 g/L, vorzugsweise 50 bis 250 g/L, sowie
- zumindest eine Komponente aus der Gruppe KOH, Ammoniak bzw. Ammoniakderivate, Amine als alkalische Komponente, andere Peroxodisulfatsalze wie z. B. Natrium- bzw. Kaliumperoxodisulfate, Peroxomonosulfate, wie z. B. Kaliumperoxomonosulfate.

13. Verfahren nach zumindest einem der vorhergehenden Ansprüche,
**dadurch gekennzeichnet,**
**dass** beim Entfernen der Präzipitate gegebenenfalls ein oberflächennaher Bereich bis zu einer Dicke d mit d ≤ 10 nm geätzt wird.

14. Verfahren nach zumindest einem der vorhergehenden Ansprüche,
**dadurch gekennzeichnet,**
**dass** ausschließlich bereichsweise die SiₓP_{y}-Phasen, elektrisch inaktives Phosphor und nicht ins Si-Kristallgitter eingebautes Phosphor entfernt werden, vorzugsweise unter Anwendung einer ätzresistenten Maske oder eines bereichsweisen Auftragens einer Ätzpaste.

15. Verfahren nach zumindest einem der vorhergehenden Ansprüche,
**dadurch gekennzeichnet,**
**dass** das zweite Dotierstoffprofil derart ausgebildet ist, dass sich im oberflächennahen Bereich des Halbleiterbauelements bis zu einer Tiefe von 40 nm eine Phosphorkonzentration zwischen 1 * 10¹⁹ P/cm³ und 5 * 10²⁰ P/cm³ ergibt.

16. Verfahren nach zumindest einem der vorhergehenden Ansprüche,
**dadurch gekennzeichnet,**
**dass** als Dotierstoffquelle eine Phosphorsäure enthaltende Lösung verwendet wird.

17. Verfahren nach zumindest einem der vorhergehenden Ansprüche,
**dadurch gekennzeichnet,**
**dass** das zweite Dotierstoffprofil derart ausgebildet wird, dass sich in einem Abstand D mit D ≅ 500 nm von der Oberfläche des Halbleiterbauelements eine Phosphorkonzentration von zumindest 1 * 10¹⁶ P/cm³ ergibt.

18. Verfahren nach zumindest einem der vorhergehenden Ansprüche,
**dadurch gekennzeichnet,**
**dass** das zweite Dotierstoffprofil derart ausgebildet wird, dass sich im oberflächennahen Bereich des Halbleiterbauelements bis zu einer Tiefe von 40 nm eine Phosphorkonzentration zwischen 1 * 10¹⁹ P/cm³ und 5 * 10²⁰ P/cm³ ergibt und dass sich in einem Abstand D mit D ≅ 500 nm von der Oberfläche des Halbleiterbauelements eine Phosphorkonzentration von zumindest 1 * 10¹⁶ P/cm³ ergibt.

## Claims

1. A method for forming a dopant profile proceeding from a surface of a plate-shaped or wafer-shaped silicon-based semiconductor device with phosphorus as a dopant by applying a phosphorus dopant source on the surface, forming a first dopant profile with the dopant source present on the surface, removing the dopant source and forming a second dopant profile having a greater depth in comparison with the first dopant profile, whereby during the forming of the first dopant profile, SiₓP_{y} phases and/or SiₓP_{y}O_{z} phases are formed on the surface,
**characterized in that**
after forming the first dopant profile, the dopant source is removed and the SiₓP_{y} phases and/or SiₓP_{y}O_{z} phases existent on the surface are selectively removed.

2. The method according to claim 1,
**characterized in that**
after removing the dopant source, SiₓP_{y} and SiₓP_{y}O_{z} phases respectively existent on the surface, electrically inactive phosphorus and free phosphorus are removed.

3. The method according to claim 1 or 2,
**characterized in that**
after forming the first dopant profile and removing the dopant source, an etch-resistant mask is applied on the surface, said mask having a geometry that corresponds to that of a metallization to be applied on the surface.

4. The method according to at least one of the previous claims,
**characterized in that**
for forming the first dopant profile, the semiconductor device is subjected to a temperature T₁ with T₁ ≥ 750 °C for a time t₁, during which a phosphorus concentration K with 10¹⁶ phosphorus atoms/cm³ ≤ K ≤ 10²¹ phosphorus atoms/cm³ arises in the surface layer of the semiconductor device in a thickness region D with 120 nm ≥ D ≥ 80 nm, and a phosphorus concentration Kₒ with K ≥ 10²⁰ phosphorus atoms/cm³ arises in the near-surface region down to a thickness Dₒ with 0 < Dₒ ≤ 50 nm, and that for forming a second dopant profile the semiconductor device is subjected to a temperature T₂ for a time t₂, whereby t₂ > t₁.

5. The method according to claim 4,
**characterized in that**
the temperature is T₂ ≥ T₁, in particular T₂ being approximately T₁, whereby 750 °C ≤ T₁, T₂ ≤ 1000 °C, in particular 800 °C ≤ T₁, T₂ ≤ 900 °C.

6. The method according to at least one of the previous claims,
**characterized in that**
the first dopant profile is formed during a time t₁ with 0.5 min ≤ t₁ ≤ 10 min, in particular 1 min ≤ t₁ ≤ 5 min, and that the second dopant profile is formed during a time t₂ with 10 min ≤ t₂ ≤ 180 min, in particular 20 min ≤ t₂ ≤ 80 min.

7. The method according to at least one of the previous claims,
**characterized in that**
the selective removal of the precipitates is conducted by using an alkaline etching solution that contains an oxidizing agent, whereby the alkaline etching solution contacts the surface in particular for a time t₃ with 5 sec ≤ t₃ ≤ 5 min, in particular 30 sec ≤ t₃ ≤ 60 sec, preferably at a temperature T₃ with RT (room temperature) ≤ T₃ ≤ 60 °C, preferably 35 °C ≤ T₃ ≤ 45 °C.

8. The method according to at least one of the previous claims,
**characterized in that**
for removing the precipitates, the surface is contacted with an alkaline etching solution containing at least one oxidizing agent from the group consisting of peroxodisulfates, peroxomonosulfates, hypochlorite, and hydrogen peroxide.

9. The method according to at least one of the previous claims,
**characterized in that**
the alkaline component of the alkaline etching solution uses at least one component selected from the group consisting of NaOH, KOH, ammonia, ammonia derivatives, alkylamines, alkanolamines, hydroxyalkyl alkylamines, polyalkylene amines, cyclic N-substituted amines, and tetraalkylammoniumhydroxide, whereby preferably the alkaline etching solution further contains at least one component selected from the group consisting of complexing agents, surfactants, and stabilizers.

10. The method according to claim 9,
**characterized in that**
a complexing agent selected from the group consisting of hydroxyphenols, amine derivatives, hydroxycarboxylic acids, polyalcohols, phosphonic acids, and polyphosphates, is used.

11. The method according to at least one of the previous claims,
**characterized in that**
as the alkaline etching solution, a dilute hypochlorite solution of the composition
- NaOH: 1 to 50 g/L, preferably 5 to 10 g/L,
- sodium hypochlorite: solution containing 6 to 14% active chlorine, 150-750 mL/L, preferably 250 to 300 mL/L, and
- KOH as a further possible component
is used.

12. The method according to at least one of the previous claims,
**characterized in that**
an alkaline etching solution containing ammonium peroxodisulfate as an oxidizing agent, with a composition:
- NaOH: 1 to 50 g/L, preferably 5 to 10 g/L,
- ammonium peroxodisulfate 5 to 350 g/L, preferably 50 to 250 g/L, as well as
- at least one component selected from the group consisting of KOH, ammonia and ammonia derivatives respectively, amines as the alkaline component, other peroxodisulfate salts such as, for instance, sodium peroxodisulfate and potassium peroxodisulfate respectively, peroxomonosulfates such as, for instance, potassium peroxomonosulfate
is used.

13. The method according to at least one of the previous claims,
**characterized in that**
during the removal of the precipitates, a near-surface region down to a thickness d with d ≤ 10 nm is etched, if necessary.

14. The method according to at least one of the previous claims,
**characterized in that**
the SiₓP_{y} phases, electrically inactive phosphorus and phosphorus that is not incorporated in the Si crystal lattice are removed solely regionally, preferably by applying an etch-resistant mask or regionally applying an etching paste.

15. The method according to at least one of the previous claims,
**characterized in that**
the second dopant profile is formed such that in the near-surface region of the semiconductor device down to a depth of 40 nm, a phosphorus concentration between 1 * 10¹⁹ P/cm³ and 5 * 10²⁰ P/cm³ results.

16. The method according to at least one of the previous claims,
**characterized in that**
a solution containing phosphoric acid is used as a dopant source.

17. The method according to at least one of the previous claims,
**characterized in that**
the second dopant profile is formed such that at a distance D with D ≅ 500 nm from the surface of the semiconductor device, a phosphorus concentration of at least 1 * 10¹⁶ P/cm³ results.

18. The method according to at least one of the previous claims,
**characterized in that**
the second dopant profile is formed such that a phosphorus concentration between 1 * 10¹⁹ P/cm³ and 5 * 10²⁰ P/cm³ results in the near-surface region of the semiconductor device down to a depth of 40 nm, and that a phosphorus concentration of at least 1 * 10¹⁶ P/cm³ results at a distance D with D ≅ 500 nm from the surface of the semiconductor device.

## Revendications

1. Procédé pour former un profil de dopant avec du phosphore en tant que dopant, à partir d'une surface d'un composant semi-conducteur à base de silicium en forme de plaque ou de tranche, par application d'une source de dopant au phosphore sur la surface, formation d'un premier profil de dopant par la source de dopant présente sur la surface, retrait de la source de dopant et formation d'un deuxième profil de dopant présentant une plus grande profondeur que le premier profil de dopant, sachant que pendant la formation du premier profil de dopant se constituent des phases SiₓP_{y} et/ou SiₓP_{y}O_{z}..
**caractérisé en ce**
**qu'**après la formation du premier profil de dopant, la source de dopant est retirée et les phases SiₓP_{y} et/ou Si_{X}P_{y}O_{z} présentes sur la surface sont éliminées de manière sélective.

2. Procédé selon la revendication 1,
**caractérisé en ce**
**qu'**après le retrait de la source de dopant, des phases SiₓP_{y} et/ou SiₓP_{y}O_{z} présentes sur la surface, du phosphore électriquement inactif et du phosphore libre sont éliminés.

3. Procédé selon la revendication 1 ou 2,
**caractérisé en ce**
**qu'**après la formation du premier profil de dopant et le retrait de la source de dopant est appliqué sur la surface un masque résistant à la gravure, qui présente une géométrie conforme à celle d'une métallisation à appliquer sur la surface.

4. Procédé selon au moins une des revendications précédentes,
**caractérisé en ce**
**que** pour former le premier profil de dopant, le composant semi-conducteur est exposé à une température T₁ telle que T₁ ≥ 750 °C pendant une durée t₁, durant laquelle dans la couche superficielle du composant semi-conducteur, dans une plage d'épaisseur D telle que 120 nm ≥ D ≥ 80 nm, s'établit une concentration de phosphore K telle que 10¹⁶ atomes de phosphore/cm³ ≤ K ≤ 10²¹ atomes de phosphore/cm³, et dans la zone proche de la surface jusqu'à une épaisseur Dₒ telle que 0 < Dₒ < 50 nm s'établit une concentration de phosphore Kₒ telle que Kₒ ≥ 10²⁰ atomes de phosphore/cm³, et que pour former le deuxième profil de dopant, le composant semi-conducteur est exposé à une température T₂ pendant une durée t₂, sachant que t₂ > t₁.

5. Procédé selon la revendication 4,
**caractérisé en ce**
**que** la température T₂ est ≥ T₁, en particulier T₂ est approximativement égale à T₁, sachant que 750 °C ≤ T₁, T₂ ≤ 1000 °C, en particulier 800 °C ≤ T₁, T₂ ≤ 900 °C.

6. Procédé selon au moins une des revendications précédentes,
**caractérisé en ce**
**que** le premier profil de dopant est formé pendant une durée t₁ telle que 0,5 min ≤ t₁ ≤ 10 min, en particulier 1 min ≤ t₁ ≤ 5 min, et que le deuxième profil de dopant est formé pendant une durée t₂ telle que 10 min ≤ t₂ ≤ 180 min, en particulier 20 min ≤ t₂ ≤ 80 min.

7. Procédé selon au moins une des revendications précédentes,
**caractérisé en ce**
**que** le retrait sélectif des précipités est effectué en utilisant une solution de gravure alcaline contenant un oxydant, sachant que la solution de gravure alcaline entre en contact avec la surface en particulier pendant une durée t₃ telle que 5 s ≤ t₃ ≤ 5 min, en particulier 30 s ≤ t₃ ≤ 60 s, de préférence sous une température T₃ telle que TA (température ambiante) ≤ T₃ ≤ 60 °C, de préférence 35 °C ≤ T₃ ≤ 45 °C.

8. Procédé selon au moins une des revendications précédentes,
**caractérisé en ce**
**que** pour le retrait des précipités, la surface est mise en contact avec une solution de gravure alcaline contenant au moins un oxydant du groupe peroxodisulfates, peroxomonosulfates, hypochlorite, peroxyde d'hydrogène.

9. Procédé selon au moins une des revendications précédentes,
**caractérisé en ce**
**que** le composant alcalin de la solution de gravure alcaline utilise au moins un composant du groupe NaOH, KOH, ammoniac, dérivés d'ammoniac, alcoylamines, alcanolamines, hydroxyalkyl-alkylamines, polyalkylène-amines, amines cycliques N-substituées, hydroxyde de tétraalkylammonium, sachant que de préférence la solution de gravure alcaline contient en outre au moins un composant du groupe agents complexants, agents tensioactifs, stabilisants.

10. Procédé selon la revendication 9,
**caractérisé en ce**
**qu'**en tant qu'agent complexant est utilisé un complexant du groupe hydroxyphénols, dérivés aminés, acides hydroxyliques, polyalcools, acides phosphoreux, polyphosphates.

11. Procédé selon au moins une des revendications précédentes,
**caractérisé en ce**
**qu'**en tant que solution de gravure alcaline est utilisée une solution diluée d'hypochlorite composée de :
- NaOH : 1 à 50 g/L, de préférence 5 à 10 g/L,
- hypochlorite de sodium : solution avec 6 à 14 % de chlore actif, 150 à 750 mL/L, de préférence 250 à 300 mL/L, et
- KOH en tant qu'autre composant possible.

12. Procédé selon au moins une des revendications précédentes,
**caractérisé en ce**
**qu'**est utilisée une solution de gravure alcaline avec peroxodisulfate d'ammonium en tant qu'oxydant, composée de :
- NaOH : 1 à 50 g/L, de préférence 5 à 10 g/L,
- peroxodisulfate d'ammonium 5 à 350 g/L, de préférence 50 à 250 g/L, ainsi que
- au moins un composant du groupe KOH, ammoniac et/ou dérivés d'ammoniac, amines en tant que composants alcalins, autres peroxodisulfates tels que peroxodisulfate de sodium et/ou peroxodisulfate de potassium, peroxomonosulfates tels que peroxomonosulfate de potassium.

13. Procédé selon au moins une des revendications précédentes,
**caractérisé en ce**
**que** lors du retrait des précipités, une zone proche de la surface est le cas échéant gravée jusqu'à une épaisseur d telle que d ≤ 10 nm.

14. Procédé selon au moins une des revendications précédentes,
**caractérisé en ce**
**qu'**exclusivement sectoriellement les phases SiₓP_{y}, le phosphore électriquement inactif et le phosphore non incorporé dans le réseau cristallin de Si sont éliminés, de préférence en utilisant un masque résistant à la gravure ou par application par secteurs d'une pâte de gravure.

15. Procédé selon au moins une des revendications précédentes,
**caractérisé en ce**
**que** le deuxième profil de dopant est formé de manière telle que dans la zone proche de la surface du composant semi-conducteur et jusqu'à une profondeur de 40 nm s'établit une concentration de phosphore comprise entre 1 * 10¹⁹ P/cm³ et 5 * 10²⁰ P/cm³.

16. Procédé selon au moins une des revendications précédentes,
**caractérisé en ce**
**qu'**en tant que source de dopant est utilisée une solution contenant de l'acide phosphorique.

17. Procédé selon au moins une des revendications précédentes,
**caractérisé en ce**
**que** le deuxième profil de dopant est formé de manière telle qu'à une distance D, où D ≈ 500 nm, de la surface du composant semi-conducteur s'établit une concentration de phosphore d'au moins 1 * 10¹⁶ P/cm³.

18. Procédé selon au moins une des revendications précédentes,
**caractérisé en ce**
**que** le deuxième profil de dopant est formé de manière telle que dans la zone proche de la surface du composant semi-conducteur et jusqu'à une profondeur de 40 nm s'établit une concentration de phosphore comprise entre 1 * 10¹⁹ P/cm³ et 5 * 10²⁰ P/cm³, et qu'à une distance D, où D ≈ 500 nm, de la surface du composant semi-conducteur s'établit une concentration de phosphore d'au moins 1 * 10¹⁶ P/cm³.
